# EUROPEAN PATENT APPLICATION

(11) **EP 4 826 117 A2**
(43) Date of publication of application: **21.10.2026**
(21) Application number: 26163277.2
(22) Date of filing: 09.03.2026
(51) Int. Cl.: C23C 16/452, C23C 16/448, C23C 16/455

(54) **METHOD OF MANUFACTURING THIN FILM AND APPARATUS FOR MANUFACTURING THIN FILM**

(30) Priority: 17.04.2025 KR 20250050017; 23.12.2025 KR 20250207841
(71) Applicant: Soulbrain Co., Ltd., Seongnam-si, Gyeonggi-do 13486 (KR)
(72) Inventor: LEE, Seung Hyun, 13486 Gyeonggi-do (KR); JUNG, Jae Sun, 13486 Gyeonggi-do (KR); PARK, Ji Won, 13486 Gyeonggi-do (KR); KIM, Deok Hyun, 13486 Gyeonggi-do (KR); KIM, Sung Gi, 13486 Gyeonggi-do (KR)
(74) Representative: Dehns

(57) **Abstract**

The present invention relates to a process of manufacturing a thin film and an apparatus for manufacturing a thin film. The present invention has an effect of providing a process and apparatus for manufacturing a thin film by an in-situ method or an ex-situ method, characterized by improving a deposition reaction rate, significantly improving density and resistivity of a deposition film, and significantly reducing impurities by improving reactivity with a subsequently injected reactant through displacement with ligands within a metal precursor via an in-situ deposition process in which hydrogen iodide is generated and provided to a deposition chamber.

## Description

### [Technical Field]

The present invention relates to a method of manufacturing a thin film and an apparatus for manufacturing a thin film. More particularly, the present invention relates to a process and apparatus for manufacturing a thin film by an in-situ method or ex-situ method using ligand substitution of a metal precursor adsorbed on a substrate with iodine produced by a hydrogen iodide conversion reaction of hydrogen gas and a solid iodine-based compound.

### [Background Art]

Hydrogen iodide and aqueous solution (acid solution) thereof have been variously produced by the phosphorus pentoxide method, hydrazine method, hydrogen-iodine method, hydrogen sulfide method, sulfur dioxide method, etc.

The phosphorus pentoxide method is a liquid phase production method of reacting 57% HI(aq) with P₂O₅, which has the advantage of high productivity, whereas the method has the disadvantage that gas collection of the product hydrogen iodide is difficult and impurities such as H₂O and O₂ are introduced.

The hydrazine method is a liquid phase production method in which iodine molecules and hydrazine react to generate hydrogen iodide and nitrogen gas, which also has the advantage of high productivity, whereas the method has the disadvantage that gas collection of the product hydrogen iodide is difficult and impurities such as H₂O and O₂ are introduced.

The hydrogen-iodine method is a solid-gas reaction that solely produces hydrogen iodide through a photo-reaction of irradiating light onto iodine molecules in a hydrogen atmosphere, having the advantage of producing the product in a high-purity gas state, whereas since a reverse reaction exists, the product inside a reactor must be continuously collected and removed to sustain the forward reaction, resulting in the disadvantage of low productivity.

The hydrogen sulfide method is a liquid phase production method of obtaining hydrogen iodide together with sulfur from hydrogen sulfide and iodine molecules, having the advantage of high productivity, whereas the method has the disadvantage that gas collection of the product hydrogen iodide is difficult and impurities such as H₂O and O₂ are introduced.

The sulfur dioxide method is a liquid phase production method of reacting iodine molecules and sulfur dioxide in an aqueous solution to obtain hydrogen iodide and sulfuric acid, which also has the advantage of high productivity, whereas the method has the disadvantage that gas collection of the product hydrogen iodide is difficult and impurities such as H₂O and O₂ are introduced, and when depositing a thin film using the method, there is a problem that the oxygen (O) impurity content inside the deposited thin film increases.

Accordingly, there is a need for research on a method and apparatus for manufacturing a thin film, which are capable of reducing impurity introduction into a deposition target thin film while improving efficiency of a subsequent reduction reaction using a reactant by substituting ligands of a metal precursor using hydrogen iodide.

### [Related Art Documents]

### [Patent Documents]

US Patent No. 2,828,184

### [Disclosure]

### [Technical Problem]

Therefore, the present invention has been made in view of the above problems, and it is one object of the present invention to provide a manufacturing process and manufacturing apparatus of an in-situ thin film or ex-situ thin film in which electrical properties are improved and impurity content is reduced by significantly improving deposition reaction rate and thickness uniformity and density of a deposition film by including a process of converting a solid iodine-based compound into hydrogen iodide in-situ or ex-situ during thin film manufacturing.

The above and other objects can be accomplished by the present invention described below.

### [Technical Solution]

In accordance with one aspect of the present invention, provided is a process of manufacturing an in-situ thin film or an ex-situ thin film, including a process of converting to hydrogen iodide by supplying a solid iodine-based compound and hydrogen gas to an activator generator;
a process of substituting ligands of a metal precursor adsorbed on a substrate by supplying gas of hydrogen iodide converted in the activator generator to a chamber loaded with the substrate; and a process of depositing an in-situ thin film or an ex-situ thin film by supplying a reactant to the chamber,
wherein the solid iodine-based compound includes one or more selected from molecular iodine (I₂), ammonium iodide (NH₄I), and potassium iodide (KI).

The process of substituting ligands of a metal precursor adsorbed on a substrate by supplying gas of hydrogen iodide converted in the activator generator to a chamber loaded with the substrate may be performed as a process of supplying the metal precursor to the chamber through a precursor feeder to generate a precursor on the substrate, and a process of substituting the ligands of the metal precursor adsorbed on the substrate using hydrogen iodide gas supplied to the chamber.

The activator generator may perform a hydrogen iodide generation reaction using light with a wavelength of 100 to 300 nm, heat of 100 to 400 °C, or plasma of 10 to 100 MHz.

The central metals of the metal precursor may include one or more selected from Al, Si, Ti, V, Cr, Mn, Fe, Co, Ni, Cu, Zn, Ga, Ge, Se, Y, Zr, Nb, Mo, Ru, Ph, In, Sn, Sb, Te, La, Ce, Hf, Ta, W, Re, Os, and Ir.

The ligands of the metal precursor may include one or more elements of C, N, O, H, Si, S, P, F, and Cl.

The metal precursor may be a molecule having a molecular weight of 15 to 400 g/mol.

The reactant may be oxygen, ozone, nitrogen monoxide, nitrogen dioxide, hydrogen, ammonia, hydrazine, or a derivative thereof.

The metal precursor, the hydrogen iodide and the reactant may be each transported to the chamber by a method independently selected from vapor flow control (VFC) to which mass flow control (MFC) is applied, mass flow control (MFC) to which liquid mass flow control (LMFC) is applied, or a liquid delivery system (LDS).

The carrier gas for transporting the metal precursor, the hydrogen iodide, or the reactant into the chamber may be one or a mixture of two or more selected from argon (Ar), nitrogen (N₂), and helium (He).

The deposition may be performed under a temperature condition of 10 to 1000 °C.

The metal precursor, the hydrogen iodide, and the reactant supplied into the chamber may be each supplied through a showerhead onto a substrate placed on a heating block.

The in-situ thin film or the ex-situ thin film may be a metal film, an oxide film, or a nitride film.

The deposition may be atomic layer deposition (ALD), plasma-enhanced atomic layer deposition (PEALD), chemical vapor deposition (CVD), plasma-enhanced chemical vapor deposition (PECVD), metal-organic chemical vapor deposition (MOCVD), or low-pressure chemical vapor deposition (LPCVD).

The method may include a hydrogen iodide gas purification process of removing impurities from the hydrogen iodide gas converted in the activator generator through a purifier, and freezing and liquefying the hydrogen iodide gas.

The process temperature may be -200 to -5 °C.

The method may include a hydrogen iodide gas filtration process for removing impurities from hydrogen iodide gas purified in the purifier.

The particle filter may have pores having a size of 0.1 to 1000 nm.

The particle filter may be made of Teflon (PFA, PTFE, and derivatives thereof) or a synthetic resin commonly used as a particle filter.

Hydrogen iodide from which impurities have been removed through a particle filter of the purifier may be bottled. For example, when a filling container is a nickel-plated gas cylinder, the inner wall of the cylinder may be formed in a passivation state by forming a self-assembled protective film in which a Ni-I atomic layer or a Ni-I₂ molecular layer is formed on the uppermost part of the plated nickel.

The ligands of the metal precursor adsorbed on the substrate may be substituted with iodine derived from hydrogen iodide, and the iodine may form a deposition film through a reduction reaction with the reactant.

In accordance with another aspect of the present invention, provided is an apparatus for manufacturing an in-situ thin film or an ex-situ thin film, including:
a deposition chamber; an activator generator for converting to hydrogen iodide by supplying a solid iodine-based compound and hydrogen gas to the activator generator; a precursor feeder for adsorbing a metal precursor onto a substrate loaded in the deposition chamber; a reactant feeder for supplying a reaction gas to the deposition chamber (10); and an inert gas feeder for supplying a purging gas to the deposition chamber (10),
wherein each material provided to the deposition chamber through the activator generator, the precursor feeder, the reactant feeder, and the inert gas feeder is independently provided by a mass flow control (MFC) method, liquid mass flow control (LMFC), or a liquid delivery system (LDS).

In the deposition chamber, a substrate may be loaded on a heating block, and the metal precursor provided from the precursor feeder, the hydrogen iodide converted in the activator generator, the reaction gas supplied from the reactant feeder, and the purging gas supplied from the inert gas feeder may be provided through a showerhead formed spaced apart from an upper part of the substrate.

The activator generator may include one or more generators selected from a light generator, a heat generator, and a plasma generator, and the light may be within a wavelength range of 100 to 300 nm, the heat may be within a range of 100 to 400 °C, and the plasma may be within a range of 10 to 100 MHz.

The apparatus may further include a purifier for removing impurities from the hydrogen iodide gas converted in the activator generator through the purifier, and freezing and liquefying the hydrogen iodide gas; and
a particle filter for removing impurities from the hydrogen iodide gas purified in the purifier.

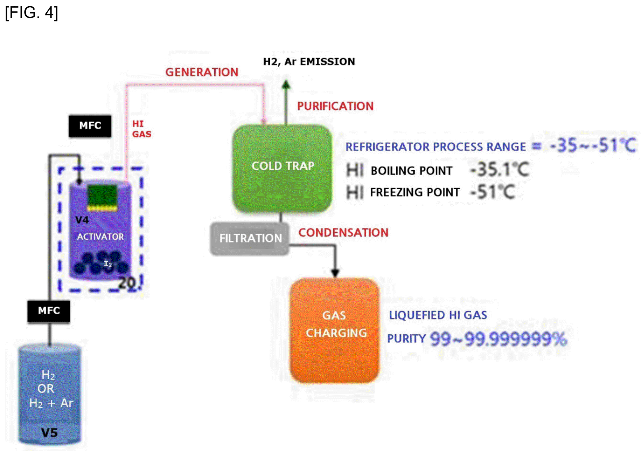

In FIG. 4 below, the purifier and particle filter are represented as a refrigerator.

In accordance with still another aspect of the present invention, provided is a semiconductor substrate including a deposition film manufactured by the process of manufacturing an in-situ thin film or an ex-situ thin film described above.

The composition of the deposition film may be confirmed through XPS analysis.

The deposition film may have a multilayer structure of two or more layers, a multilayer structure of three or more layers, or a multilayer structure of two or three layers.

The deposition film may have a deposition thickness of 500 Å or less as measured by an ellipsometer.

The deposition film may have a resistivity of 300 µΩ·cm or less.

The density of the deposition film may be 4.5 g/cm³ or more.

The deposition film may have an iodine atom count of 50 counts/s or more as measured by SIMS.

The deposition film may be an oxide film, a nitride film, a metal film, or a sulfide film, and may be used as a diffusion barrier, an etch stop layer, an electrode film, a dielectric film, a gate insulating film, a blocking oxide film, or a charge trap.

In accordance with yet another aspect of the present invention, provided is a semiconductor device including the semiconductor substrate described above.

### [Advantageous Effects]

According to the present invention, the present invention has an activation effect of improving deposition film productivity by changing a leaving group of a precursor adsorbed on a substrate to iodine to improve a deposition reaction rate and appropriately increase thickness uniformity and density of a deposition film.

In addition, the present invention has an effect of improving the electrical characteristics of a deposition film by effectively reducing the content of process by-products, which increased due to a compound providing iodine, thereby preventing corrosion or deterioration and improving crystallinity of the deposition film.

In addition, the present invention has an effect of providing a method of manufacturing an in-situ thin film or an ex-situ thin film and an apparatus for manufacturing a thin film, which are capable of improving the thickness uniformity of a deposition film even having a complex structure, and a semiconductor substrate and semiconductor device fabricated therefrom.

### [Description of Drawings]

FIG. 1 is a flowchart for explaining a method of manufacturing a thin film and an apparatus for manufacturing a thin film according to the present invention.
FIG. 2 is a process diagram for explaining an in-situ thin film manufacturing process according to Example 1 of the present invention.
FIG. 3 is a diagram for explaining an activator generation process in an activator generator 20 of FIG. 1.
FIG. 4 is a schematic diagram of a manufacturing process for producing hydrogen iodide by an ex-situ method.
FIG. 5 includes schematic diagrams showing various process diagrams using FIGS. 2 to 4, wherein process diagram 1 schematically shows a process sequence according to FIG. 2, process diagram 2 schematically shows a process sequence according to FIG. 4, and process diagram 3 schematically shows up to a step of filling a gas cylinder with hydrogen iodide prepared according to FIG. 4.

### [Best Mode]

Hereinafter, a method of manufacturing an in-situ thin film or an ex-situ thin film and an apparatus for manufacturing a thin film according to the present invention will be described in detail.

In the present disclosure, the term "in-situ", unless otherwise specified, refers to a technology of generating and applying high-purity hydrogen iodide during the thin film manufacturing process, and as a result, impurity content in the obtained thin film may be reduced and the effect of substituting ligands of a metal precursor may be maximized.

The present inventors confirmed that by generating hydrogen iodide capable of substituting ligands leaving from a metal precursor used to form a deposition film on a surface of a substrate loaded inside a chamber during a thin film manufacturing process and applying in-situ, the deposition reaction rate was improved and thickness uniformity of the deposition film was secured while significantly improving density and resistivity of the deposition film, and Cl, O, Si, H, NH, metal, and metal oxides remaining as process by-products were reduced. Based on these results, the present inventors completed the present invention by conducting further research on a method of manufacturing an in-situ thin film or an ex-situ thin film and an apparatus for manufacturing a thin film.

Specifically, the process of manufacturing an in-situ thin film or an ex-situ thin film according to the present invention may include a process of converting to hydrogen iodide by supplying a solid iodine-based compound and hydrogen gas to an activator generator (hereinafter referred to as process A-1); a process of substituting ligands of a metal precursor adsorbed on a substrate by supplying gas of hydrogen iodide converted in the activator generator to a chamber loaded with the substrate (hereinafter referred to as process A-2); and a process of depositing an in-situ thin film or an ex-situ thin film by supplying a reactant to the chamber (hereinafter referred to as process A-3).

The apparatus for manufacturing an in-situ thin film or an ex-situ thin film according to the present invention may include a deposition chamber 10; an activator generator 20 for converting into hydrogen iodide by supplying a solid iodine-based compound and hydrogen gas to the activator generator; a precursor feeder 30 for adsorbing a metal precursor onto a substrate loaded in the deposition chamber 10; a reactant feeder 40 for supplying a reaction gas to the deposition chamber 10; and an inert gas feeder 50 for supplying a purging gas to the deposition chamber 10.

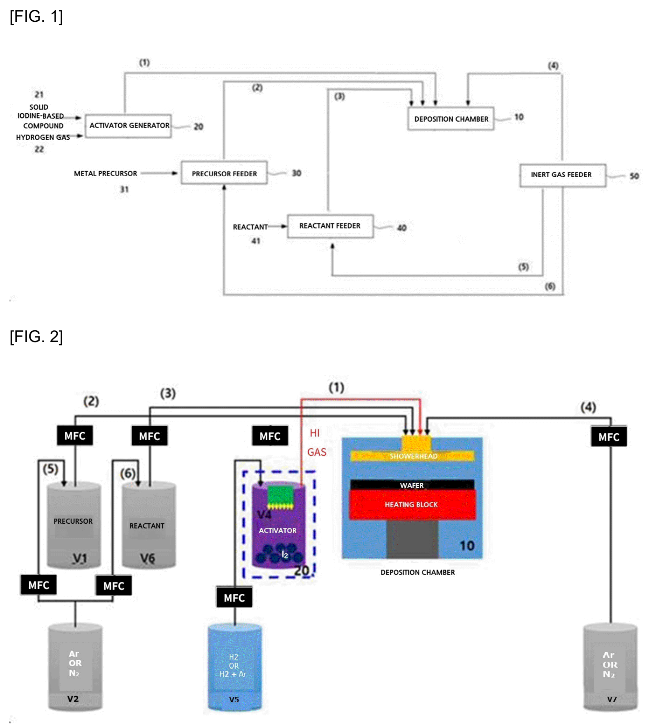

The process and apparatus for manufacturing an in-situ thin film or an ex-situ thin film according to the present invention will be described in detail with reference to FIGS. 1 to 5 as follows.

The process A-1 is a process of generating hydrogen iodide from a solid iodine-based compound, which is an activator reaction material, and hydrogen gas. The process A-1 may consist of a process of supplying hydrogen gas to the activator generator 20 equipped with the solid iodine-based compound, or supplying hydrogen gas and the solid iodine-based compound respectively to the activator generator 20 to convert the hydrogen gas and the solid iodine-based compound into hydrogen iodide.

The solid iodine-based compound is a deposition additive compound used to better form a deposition film on the surface of a substrate loaded inside the deposition chamber 10. For example, the solid iodine-based compound may include one or more selected from molecular iodine (I₂), ammonium iodide (NH₄I), and potassium iodide (KI). In this case, it is possible to improve reaction efficiency by effectively substituting ligands to be released from the metal precursor with low binding energy, as well as having excellent reduction reaction capability with a reactant described later.

The solid iodine-based compound may preferably be a compound with a purity of 99.9% or more, a compound with a purity of 99.95% or more, or a compound with a purity of 99.99% or more. For reference, when using a compound with a purity of less than 99%, impurities may remain in the deposition film or cause side reactions with the precursor or reactant, so it is recommended to use a material of 99% or more.

The solid iodine-based compound preferably has a density of 2.0 to 6.0 g/cm³ or 2.5 to 5.0 g/cm³, and the vapor pressure may be 1 atm or less at 273 K. Within this range step coverage, thickness uniformity of the deposition film, resistivity, and film quality may be improved. In particular, by suppressing side reactions and controlling the deposition film growth rate, process by-products in the deposition film are reduced to reduce corrosion or deterioration, the crystallinity of the deposition film is improved, a stoichiometric oxidation state is reached when forming a metal oxide film, and step coverage and thickness uniformity of the deposition film are significantly improved even when forming a deposition film on a substrate having a complex structure.

As a specific example, under room temperature conditions, the density may be about 4.9 g/cm³ for I₂ molecule, about 3.1 g/cm³ for KI molecule, and about 2.5 g/cm³ for NH₄I molecule.

For reference, the density upon melting iodine may be 3.9g/cm³.

In addition, for iodine, 240 K is -33 °C, and the vapor pressure at this temperature is about 1 mTorr, which is estimated to be 0.000001 atm when converted to atmospheric pressure.

As a specific example, the solid iodine-based compound may be a single substance of hydrogen iodide of 3N to 15N, a gas mixture of 1 to 99 % by weight of hydrogen iodide of 3N to 15N and an inert gas as a balance such that a total amount becomes 100 % by weight, or an aqueous solution mixture of 0.5 to 70 % by weight of hydrogen iodide of 3N to 15N and water as a balance such that a total amount becomes 100 % by weight. Here, when the inert gas is nitrogen, helium, or argon of 4N to 9N, the effect of reducing process by-products is significant, step coverage is excellent, and the effect of improving deposition film density and the electrical properties of the deposition film may be superior.

Preferably, the solid iodine-based compound is a single substance of hydrogen iodide of 3N to 7N, a gas mixture of 1 to 99 % by weight of hydrogen iodide of 5N to 6N and the balance of an inert gas such that a total amount becomes 100 % by weight, or an aqueous solution mixture of 0.5 to 70 % by weight of hydrogen iodide of 5N to 6N and the balance of water such that a total amount becomes 100 % by weight, wherein the inert gas may be nitrogen, helium, or argon of 4N to 9N. In this case, when forming a deposition film, a substitution region that does not remain in the deposition film is formed to form a relatively sparse deposition film while suppressing side reactions and controlling the deposition film growth rate, thereby reducing process by-products in the deposition film to reduce corrosion or deterioration, improving the crystallinity of the deposition film, and significantly improving step coverage and thickness uniformity of a deposition film even when forming the deposition film on a substrate having a complex structure.

When using I₂ as the solid iodine-based compound, specifically, process A-1 may include a reaction represented by Reaction Formula 1 below.

[Reaction Formula 1] H₂(g) + I₂(s) -> 2HI(g)

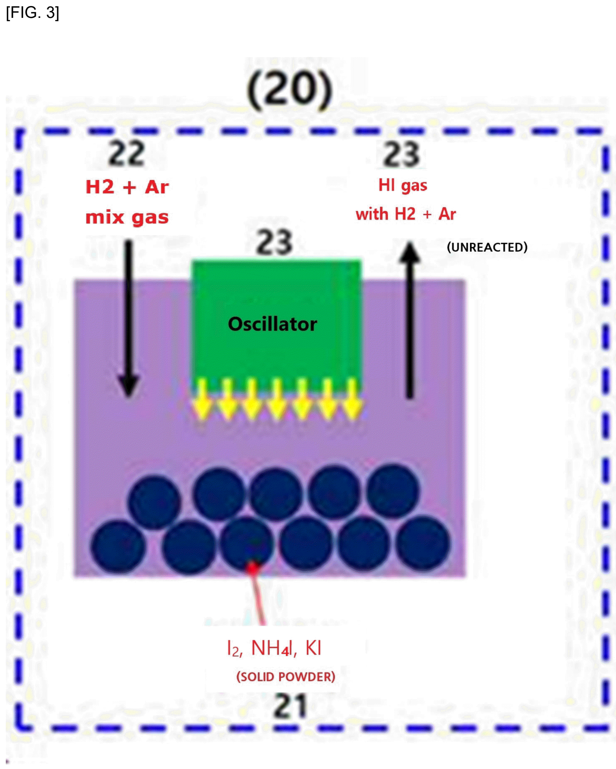

Reaction Formula 1 is schematically illustrated in FIG. 3 below.

FIG. 3 below is a diagram for explaining the activator generation process in the activator generator 20 of FIG. 1 below. FIG. 1 below is a diagram showing a flowchart for explaining a method of manufacturing an in-situ thin film or an ex-situ thin film and an apparatus for manufacturing a thin film according to the present invention. FIG. 2 below is a process diagram for explaining a process of manufacturing an in-situ thin film or an ex-situ thin film according to Example 1 of the present invention. Hereinafter, reference is made to the flowchart of process diagram 1 and the process diagram in FIGS. 1, 2, and 5 below.

For reference, FIG. 3 illustrates a case where solid powder 21 such as I₂, NH₄I, and KI is included as the solid iodine-based compound in the activator generator 20 as an example, and the solid iodine-based compound may be provided by being included in a canister or the like outside, not inside the activator generator 20.

When a mixed gas 22 of hydrogen gas and carrier gas is injected, the solid powder 21 reacts to form a hydrogen iodide gas 23, and unreacted hydrogen gas and carrier gas remain.

Thermodynamically, the reaction may proceed to a complete reaction as the temperature increases, and the conversion rate of hydrogen iodide may decrease as the temperature decreases. Thus, the activator generator 20 may include one or more generators selected from a light generator, a heat generator, and a plasma generator.

Here, the light may be within a wavelength range of 100 to 300 nm.

The heat may be within a range of 100 to 400 °C.

The plasma may be within a range of 10 to 100 MHz.

The reaction may be performed in one step, but may be performed in two steps to increase reaction efficiency in consideration of a reverse reaction. Taking the case of using a heat generator as an example, the reaction may be performed by undergoing a high-temperature generation reaction in which the reaction occurs at a high temperature of 300 to 400 °C and a low-temperature generation reaction in which the reaction occurs at a temperature of 100 to 200 °C.

The high-temperature generation reaction may be performed using a molar ratio of H₂ to I₂ of 10:1 to 1:1, a reaction temperature of 300 to 400 °C, light with a wavelength of 200 to 300 nm, or plasma of 5 to 50 MHz.

The low-temperature generation reaction may be performed using a molar ratio of H₂ to I₂ of 10:1 to 1:1, a reaction temperature of 100 to 300 °C, light with a wavelength of 100 to 200 nm, or plasma of 5 to 50 MHz.

In process A-1, the hydrogen gas supplied to the activator generator 20 may have a purity of 90 % or more, preferably 95 % or more, still more preferably 99 % or more.

The activator generator 20 used in the process A-1 may be performed using a vessel V4. The vessel V4 may be of a material that does not react with iodine and hydrogen radicals, and may be, for example, a canister or crucible made of Hastelloy C22 material.

The gas generated through process A-1 may be supplied to the deposition chamber 10 as a stream 1 containing hydrogen iodide and hydrogen.

Since the hydrogen iodide gas obtained through such process A-1 is directly supplied to the deposition chamber 10 without a separate separation process, a separate collection or purification process is omitted, so that the efficiency of the manufacturing process, that is, economic feasibility, may be increased compared to the conventional art.

That is, it is preferable that the hydrogen iodide gas obtained through process A-1 is directly supplied to process A-2 described later.

The hydrogen iodide may be transported to the deposition chamber 10 by a method independently selected from vapor flow control (VFC) to which mass flow control (MFC) is applied, mass flow control (MFC) to which liquid mass flow control (LMFC) is applied, or a liquid delivery system (LDS).

Here, when transporting in a gas phase, the hydrogen iodide may be transported to the deposition chamber 10 after passing through a vaporizer (not shown).

The carrier gas for moving the hydrogen iodide into the deposition chamber 10 may be one or a mixture of two or more selected from argon (Ar), nitrogen (N₂), and helium (He).

The feeding time (sec) of the hydrogen iodide is preferably 0.001 to 30 seconds per cycle, more preferably 0.02 to 30 seconds, still more preferably 0.04 to 30 seconds, still more preferably 0.05 to 30 seconds. Within this range, the deposition film growth rate may be high and step coverage and economic feasibility may be excellent.

In the present disclosure, the feeding time of hydrogen iodide is based on a flow rate of 10 to 5000 sccm based on a chamber volume of 15 to 20 L, and more specifically based on a flow rate of 100 to 2500 sccm in a chamber volume of 18 L.

The hydrogen iodide supplied into the deposition chamber 10 may be supplied onto a substrate placed on a heating block through a showerhead (see FIG. 2).

The deposition chamber 10 may be an atomic layer deposition (ALD) chamber, a plasma-enhanced atomic layer deposition (PEALD) chamber, a chemical vapor deposition (CVD) chamber, a plasma-enhanced chemical vapor deposition (PECVD) chamber, a metal-organic chemical vapor deposition (MOCVD) chamber, or a low-pressure chemical vapor deposition (LPCVD) chamber.

The deposition chamber 10 may perform purging pretreatment after loading the substrate.

In the present disclosure, purging corresponds to a purging process described later, and is performed at preferably 1,000 to 50,000 sccm (Standard Cubic Centimeter per Minute), more preferably 2,000 to 30,000 sccm, still more preferably 2,500 to 15,000 sccm. Within this range, the deposition film growth rate per cycle may be appropriately controlled. In addition, since deposition is performed as an atomic mono-layer or nearly an atomic mono-layer, the film quality may be improved.

The substrate loaded into the deposition chamber 10 may include a semiconductor substrate, such as a silicon substrate or a silicon oxide substrate.

The substrate may further have a conductive layer or an insulating layer formed on the upper portion thereof.

The substrate may be maintained at 50 to 500 °C, or 80 to 500 °C.

For example, the substrate may be heated to 50 to 500 °C, as a specific example, 80 to 500 °C, 100 to 800 °C, or 200 to 500 °C, and the hydrogen iodide described later as well as the metal precursor may be injected onto the substrate in an unheated state or a heated state, and depending on deposition efficiency, heating conditions may be adjusted during the deposition process after being injected without being heated. For example, the hydrogen iodide and the metal precursor may be injected for 1 to 30 seconds onto a substrate heated to 300 to 600 °C.

Process A-2 is a process of substituting ligands of the metal precursor, and may consist of a process of supplying hydrogen iodide gas converted in the activator generator 20 to the deposition chamber 10 loaded with a substrate to substitute ligands of the metal precursor adsorbed on the substrate. Process A-2 may be performed in one step, but may be performed in two steps to increase reaction efficiency. Specifically, Process A-2 may be performed by a process of supplying a metal precursor to the deposition chamber 10 through the precursor feeder 30 to generate a precursor on the substrate, and a process of substituting ligands of the metal precursor adsorbed on the substrate using hydrogen iodide gas supplied to the deposition chamber 10.

The precursor feeder 30 may be performed using a vessel V1. The vessel V1 may be of a material that does not react with the precursor, and may be, for example, a canister or crucible made of Hastelloy C22 material.

FIG. 4 below is a schematic diagram of a manufacturing process for producing hydrogen iodide by an ex-situ method.

Specifically, the method may include a hydrogen iodide gas purification process of removing impurities from the hydrogen iodide gas converted in the above-described activator generator (See related explanation in FIG. 2) through a purifier, and freezing and liquefying the hydrogen iodide gas.

The process temperature may be -200 to -5 °C.

The method may include a hydrogen iodide gas filtration process for removing impurities from hydrogen iodide gas purified in the purifier.

The pores of the particle filter may be within a size of 0.1 to 1000 nm.

The particle filter may be made of Teflon (PFA, PTFE, and derivatives thereof) or a synthetic resin commonly used as a particle filter.

Hydrogen iodide from which impurities have been removed through the particle filter of the purifier may be bottled.

For example, when a bottling (filling) container is a nickel-plated gas cylinder, the inner wall of the cylinder may be formed in a passivation state by forming a self-assembled protective film in which a Ni-I atomic layer or a Ni-I₂ molecular layer is formed on the uppermost part of the plated nickel.

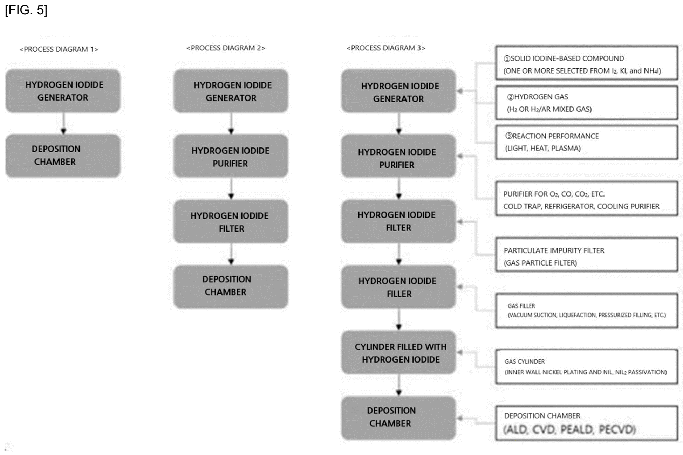

FIG. 5 below is a schematic diagram showing various process diagrams using FIGS. 2 to 4. Process diagram 2 in FIG. 5 below is a view systematically showing the process sequence according to FIG. 4. Process diagram 3 in FIG. 5 below schematically shows steps up to filling hydrogen iodide prepared according to FIG. 4 into a gas cylinder.

Specifically, the process of generating a precursor on the substrate may apply various methods known as deposition techniques using conventional metal precursors, and as a specific example, may include atomic layer deposition (ALD), plasma-enhanced atomic layer deposition (PEALD), chemical vapor deposition (CVD), plasma-enhanced chemical vapor deposition (PECVD), metal-organic chemical vapor deposition (MOCVD), or low-pressure chemical vapor deposition (LPCVD).

The central metals (M) of the metal precursor may include one or more selected from Al, Si, Ti, V, Cr, Mn, Fe, Co, Ni, Cu, Zn, Ga, Ge, Se, Y, Zr, Nb, Mo, Ru, Ph, In, Sn, Sb, Te, La, Ce, Hf, Ta, W, Re, Os, and Ir.

The ligands of the metal precursor may include one or more elements of C, N, O, H, Si, S, P, F, and Cl, and specifically, may be -Cl, -Cp, -N(Me₃)₂, or the like.

For example, the ligands may be L1, L2, L3, L4, L_{1'}, L_{2'}, L_{3'}, and L_{4'} and may be the same as or different from each other.

For example, L₁ may be -guanidiate, -amidinate, -triazenide, -iPr, -tBu, -Cp, - Ph, or -OR, R may be -CH₃, -CH₂CH₃, -iPr, or -tBu, and L₂, L₃, and L₄ may be each independently -H, -CH₃, -CH₂CH₃, -OH, and -NR₂.

As another example, L₁ and L₂ may be each independently -iPr, -tBu, -Cp, -Ph, or -OR, R may be -H, -CH₃, -CH₂CH₃, -iPr, or -tBu, and L₃ and L₄ may be each independently -H, -CH₃, -CH₂CH₃, -OH, and -NR₂.

As another example, L₁, L₂, and L₃ may be each independently -iPr, -tBu, -Cp, -Ph, or -OR, R may be -H, -CH₃, -CH₂CH₃, -iPr, or -tBu, and L₄ may be -H, -CH₃, -CH₂CH₃, -OH, or -NR₂.

As another example, L_{1'}, L_{2'}, L_{3'}, and L_{4'} may be each independently -iPr, -tBu, -Cp, -Ph, or -OR, and R may be -H, -CH₃, -CH₂CH₃, -iPr, or -tBu.

The ligands may form a symmetrical or asymmetrical structure.

In the present disclosure, unless otherwise stated, Pr represents a propyl group and Bu represents a butyl group.

In the case of a precursor having a vapor pressure of 1 mTorr to 100 Torr at 25 °C, the metal precursor may maximize the effect of filling the aforementioned ligand leaving site.

For example, in the present invention, the metal precursor may be mixed with a non-polar solvent and introduced into the chamber. In this case, the viscosity or vapor pressure of the metal precursor may be easily adjusted.

The non-polar solvent may preferably include one or more selected from the group consisting of alkanes and cycloalkanes. In this case, an organic solvent with low reactivity and solubility and easy moisture management may be included. In addition, step coverage may be improved even when deposition temperature increases during deposition film formation.

As a more preferred example, the non-polar solvent may include a C1 to C10 alkane or a C3 to C10 cycloalkane, preferably a C3 to C10 cycloalkane. In this case, reactivity and solubility may be low and moisture management may be easy.

In the present disclosure, C1, C3, and the like indicate the number of carbon atoms.

The cycloalkane may preferably include C3 to C10 monocycloalkanes, and among the monocycloalkanes, cyclopentane is liquid at room temperature and has the highest vapor pressure, so cyclopentane is preferable in the vapor deposition process, but the present invention is not limited thereto.

For example, the non-polar solvent may have a solubility (25 °C) of 200 mg/L or less, preferably 50 to 400 mg/L, more preferably 135 to 175 mg/L in water. Within this range, reactivity to the metal precursor may be low, and moisture management may be easy.

In the present disclosure, solubility may be measured without any particular limitation by a measurement method or standard commonly used in the technical field to which the present invention pertains. For example, solubility may be measured by the HPLC method using a saturated solution.

The non-polar solvent may be preferably included in an amount of 5 to 95 % by weight, more preferably 10 to 90 % by weight, still more preferably 40 to 90 % by weight, most preferably 70 to 90 % by weight based on the total weight of the sum of the metal precursor and the non-polar solvent.

When the content of the non-polar solvent exceeds the above range, impurities may be generated, which may increase the resistance and impurities within a deposition film. When the content of the organic solvent is less than the range, the effect of improving step coverage due to solvent addition and the effect of reducing impurities may be reduced.

The metal precursor may use a molecule having a molecular weight within a range of 15 to 400, or 50 to 400 g/mol. In this case, it is possible to provide appropriate vapor pressure implementation and mass transfer effect of moving to the inside of a pattern hole.

For example, as the metal precursor, TiCl₄, Star-Ti (CpMe₅-Ti(OMe)₃), TDMAT (Ti(NMe₂)₄), TTIP (Ti(OiPr)₄), CpTi(NMe₂)₃, CpMe-Ti(NMe₂)₃, CMENT, Ti-Prime (CpMe-Ti(OiPr)₃), or compounds presented by Chemical Formulas 1 to 7 below may be used.

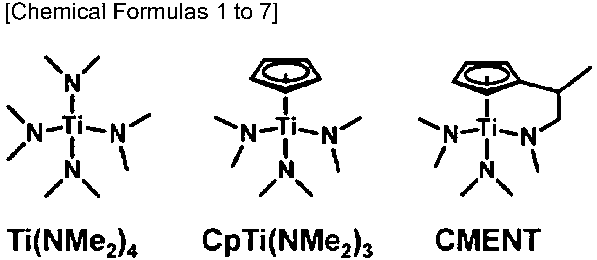

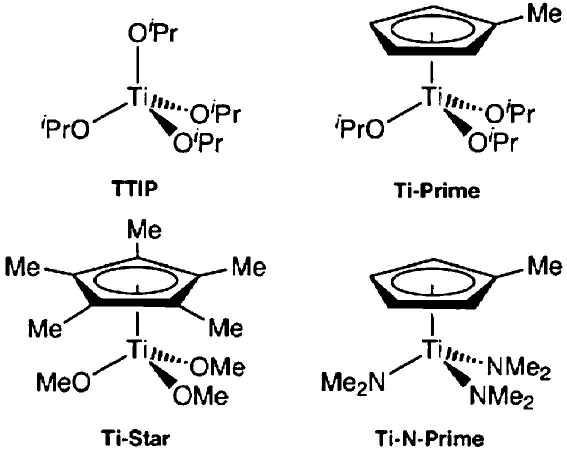

According to the process of substituting ligands of the metal precursor adsorbed on the substrate using hydrogen iodide gas supplied to the deposition chamber 10, ligands of the metal precursor may be substituted with iodine by hydrogen iodide supplied from the activator generator 20. In this case, the leaving group of the precursor adsorbed on the substrate is effectively changed to improve the reaction speed and appropriately reduce the deposition film growth rate, which has the effect of significantly improving step coverage, resistivity, and thickness uniformity of the deposition film even when forming a deposition film on a substrate having a complex structure.

The molar ratio of hydrogen iodide to the metal precursor is 10:1 to 1:1, and the process may be performed under conditions of a deposition temperature of 10 to 1000 °C and a deposition pressure of 0.05 to 20 Torr.

The input amount (mg/cycle) of the metal precursor into the deposition chamber 10 is such that the ratio of the input amount (mg/cycle) of hydrogen iodide to the metal precursor into the deposition chamber 10 is, for example, 1:1 to 1:20, preferably 1:1 to 1:15, more preferably 1:1 to 1:10. Within this range, the effect of improving step coverage and reducing process by-products is significant.

The metal precursor may be transported from the precursor feeder 30 to the deposition chamber 10 through stream 2. The stream 2 may apply a method independently selected from vapor flow control (VFC) to which a mass flow controller (MFC) method is applied, mass flow control (MFC) to which liquid mass flow control (LMFC) is applied, or a liquid delivery system (LDS).

Here, when transporting in a gas phase, the metal precursor may be transported to the deposition chamber 10 after passing through a vaporizer (not shown).

The carrier gas for moving the metal precursor into the deposition chamber 10 may be one or a mixture of two or more selected from argon (Ar), nitrogen (N₂), and helium (He).

The metal precursor supplied into the deposition chamber 10 may be supplied onto a substrate placed on a heating block through a showerhead (see FIG. 2 below).

Process A-3 is a process of depositing an in-situ thin film or an ex-situ thin film, and may consist of a process of depositing an in-situ thin film or an ex-situ thin film by supplying a reactant from the reactant feeder 40 to the deposition chamber 10.

For example, the reactant may be oxygen, ozone, nitrogen monoxide, nitrogen dioxide, hydrogen, ammonia, hydrazine, or a derivative thereof.

The reactant feeder 40 used in process A-3 may be performed using a vessel V6. For example, the vessel V6 may be SUS304, SUS316, SUS316L, or a canister or crucible made of Hastelloy C22 material, etc.

The reactant may be transported from the reactant feeder 40 to the deposition chamber 10 through a stream 3. The stream 3 may be transported to the deposition chamber 10 by a method independently selected from vapor flow control (VFC) to which mass flow control (MFC) is applied, mass flow control (MFC) to which liquid mass flow control (LMFC) is applied, or a liquid delivery system (LDS).

Here, when transporting in a gas phase, the reactant may be transported to the deposition chamber 10 after passing through a vaporizer (not shown).

The carrier gas for moving the reactant into the deposition chamber 10 may be one or a mixture of two or more selected from argon (Ar), nitrogen (N₂), and helium (He).

The reactant supplied into the deposition chamber 10 may be supplied onto a substrate placed on a heating block through a showerhead (see FIG. 2 below).

After the ligands of the metal precursor adsorbed on the substrate are substituted with iodine derived from hydrogen iodide in process A-2, the iodine forms a deposition film through a reduction reaction with the reactant in process A-3.

The deposition film may be referred to as a so-called in-situ thin film or ex-situ thin film, and as a specific example, the deposition film may be a metal film, an oxide film, or a nitride film.

The deposition film may have a deposition thickness of 170 Å or less, or 100 to 170 Å, as measured by SIMS.

The resistivity of the deposition film may be 300 µΩ·cm or less, or 150 to 300 µΩ·cm, and electrical conductivity may be improved within this range.

The deposition rate of the deposition film may be 0.34 Å/cycle or more, or 0.34 to 0.535 Å/cycle.

The density of the deposition film may be 4.8 g/cm³ or more, or 4.8 to 5.3 g/cm³.

The deposition film may have a deposition rate increase rate represented by Equation 1 below of 10 % or more, as a specific example, 12.5 % or more, preferably 15 % or more. In this case, the growth rate of the deposition film is significantly lowered, so that even when applied to a substrate of a complex structure, uniformity of the deposition film is secured, step coverage is significantly improved, deposition is possible with a particularly thin thickness, and O, Si, metal, and metal oxides remaining as process by-products are reduced. In addition, it can provide an effect of improving residual carbon, which was not easy to reduce in the related art. [Equation 1] $Deposition rate increase rate = \left[\left({DR}_{f}\right)/\left({DR}_{i}\right)\right] \times 100$

(In Equation 1, DR (deposition rate, Å/cycle) is the rate at which the deposition film is deposited. In the deposition of a deposition film formed of a quasi-metal precursor and a reactant, DRᵢ (initial deposition rate) is the deposition rate of a deposition film formed without injecting hydrogen iodide, and DR_{f} (final deposition rate) is the deposition rate of a deposition film formed by injecting hydrogen iodide when proceeding with the same process. Here, the deposition rate (DR) is a value measured for a deposition film with a thickness of 1 to 30 nm using ellipsometer equipment under room temperature and atmospheric pressure conditions, and uses the unit of Å/cycle.)

In Equation 1, the deposition film growth rate per cycle when hydrogen iodide is used and when hydrogen iodide is not used means the deposition film deposition thickness (Å/cycle) per each cycle, that is, the deposition rate. The deposition rate may be obtained as an average deposition rate by measuring the final thickness of a deposition film of 1 to 30 nm thickness under room temperature and atmospheric pressure conditions using, for example, ellipsometry, and then dividing the final thickness by the total number of cycles.

In Equation 1, "when hydrogen iodide is not used" means a case where a deposition film is manufactured by adsorbing only a metal precursor on a substrate in a deposition film deposition process. As a specific example, it refers to a case where a deposition film is formed by omitting the step of adsorbing hydrogen iodide and the step of purging unadsorbed hydrogen iodide in the method of forming a deposition film.

For example, the method of forming a deposition film may be performed at a deposition temperature in the range of 50 to 800 °C, preferably at a deposition temperature in the range of 100 to 700 °C, more preferably at a deposition temperature in the range of 200 to 650 °C, still more preferably at a deposition temperature in the range of 220 to 500 °C, and still more preferably at a deposition temperature in the range of 220 to 450 °C. Within this range, there is an effect of growing into a deposition film of excellent film quality while implementing process characteristics.

For example, the method of forming a deposition film may be performed at a deposition pressure in the range of 0.01 to 20 Torr, preferably at a deposition pressure in the range of 0.1 to 20 Torr, more preferably at a deposition pressure in the range of 0.1 to 10 Torr. Within this range, a deposition film of uniform thickness may be obtained.

In the present disclosure, deposition temperature and deposition pressure may be measured as the temperature and pressure formed inside the deposition chamber, or may be measured as the temperature and pressure applied to the substrate inside the deposition chamber.

For example, the method of forming a deposition film uses a step of adsorbing a metal precursor on a substrate, a step of purging unadsorbed metal precursor, a step of supplying hydrogen iodide onto the substrate on which the precursor is adsorbed, a step of purging unadsorbed hydrogen iodide, a step of supplying a reactant, and a step of purging residual reactant and by-products as a unit cycle, and the unit cycle may be repeated to form a deposition film of a desired thickness.

The method of forming a deposition film may repeat the unit cycle 1 to 99,999 times as needed, preferably 10 to 10,000 times, more preferably 50 to 5,000 times, still more preferably 100 to 2,000 times. Within this range, the effects intended to be achieved in the present invention may be sufficiently obtained while obtaining the desired thickness of the deposition film.

Process A-1, process A-2, and process A-3 may include a purging process (hereinafter referred to as process A-4) as needed before and after the start of each process. The purging process may be selectively performed as needed using a purging gas provided from the inert gas feeder 50. That is, the purging process is performed to remove substances or by-products when the substances injected into the deposition chamber 10 remain in each process or when by-products are excessively generated, and inert gas and one or a mixture of two or more selected from argon (Ar), nitrogen (N₂), and helium (He) supplied from the feeder 50 may be used.

The inert gas feeder 50 may be performed using a vessel V7. The vessel V7 may be, for example, a canister or crucible made of Hastelloy C22 material, etc.

The purging process may be included one or more times.

The amount of purge gas introduced into the deposition chamber 10 in the purging process is not particularly limited as long as the amount is an amount sufficient to remove unadsorbed or unreacted substances, but for example, the amount may be 10 to 100,000 times, preferably 50 to 50,000 times, more preferably 100 to 10,000 times based on the volume of the metal precursor introduced into the deposition chamber 10. Within this range, unadsorbed substances are sufficiently removed so that the deposition film is formed evenly and deterioration of film quality may be prevented. Here, the input amounts of the purge gas and metal precursor are each based on one cycle, the volume of the metal precursor means the volume of vaporized metal precursor vapor, and the volume of hydrogen iodide means the volume of vaporized hydrogen iodide vapor.

For example, when hydrogen iodide is injected at a flow rate of 100 sccm and an injection time of 0.5 sec (per 1 cycle), and purge gas is injected at a flow rate of 3000 sccm and an injection time of 5 sec (per 1 cycle) in the step of purging unadsorbed hydrogen iodide, the injection amount of purge gas is 300 times the injection amount of hydrogen iodide.

In the present disclosure, purging is performed at preferably 1,000 to 50,000 sccm (Standard Cubic Centimeter per Minute), more preferably 2,000 to 30,000 sccm, and still more preferably 2,500 to 15,000 sccm. Within this range, the deposition film growth rate per cycle may be appropriately controlled, and deposition is performed as an atomic mono-layer or nearly an atomic mono-layer, which is advantageous in terms of film quality.

The substance may be transported from the inert gas feeder 50 to the deposition chamber 10 through a stream 4. Stream 4 may be transported by a method independently selected from vapor flow control (VFC) to which mass flow control (MFC) is applied, mass flow control (MFC) to which liquid mass flow control (LMFC) is applied, or a liquid delivery system (LDS).

In addition, one or a mixture of two or more selected from argon (Ar), nitrogen (N₂), and helium (He) supplied from the inert gas feeder 50 may be transported to the precursor feeder 30 of process A-2 or transported to the reactant feeder 40 of process A-3 as needed. In this case, reaction efficiency may be improved by assisting the transport of the precursor or reactant transported to the deposition chamber 10.

The process of manufacturing an in-situ thin film or an ex-situ thin film may further include a process of gas-liquid separation of the product containing hydrogen iodide as needed. In this case, a gas-liquid separator (not shown) may be further provided.

When the injection time and purge time of the metal precursor are a and b respectively, the injection time and purge time of hydrogen iodide are c and d respectively, and the injection time and purge time of the reactant are e and f respectively, 0.1≤a≤30, a≤b≤3a, 0.1<c≤30, c≤d≤4c, 2<e≤60, and e≤f≤3e may be simultaneously satisfied.

When injection and purging of the metal precursor and hydrogen iodide, and injection and purging of the reactant are considered 1 cycle, the following 4 conditions may all be satisfied: 1) the deposition film has a deposition thickness of 500 Å or less as measured by an ellipsometer, 2) the resistivity of the deposition film is 300 µΩ·cm or less, 3) the deposition rate is 0.34 Å/cycle or more, and 4) the density of the deposition film is 4.5 g/cm³ or more.

The deposition film may include a metal film, an oxide film, a nitride film alone, or a sulfide film or chalcogenide in a nitride film. In this case, the effects intended to be achieved in the present invention may be sufficiently obtained.

The deposition film may include the aforementioned film composition alone or as a selective area, but is not limited thereto, and is meant to include SiH and SiOH.

The deposition film may be utilized in a semiconductor device for uses such as an etch stop layer, an electrode film, a dielectric film, a gate insulating film, a block oxide film, or a charge trap, as well as a generally used diffusion barrier.

The deposition film may have a deposition thickness of 500 Å or less, or 2 to 300 Å, preferably 5 to 250 Å as measured by an ellipsometer.

The deposition film may have resistivity of 300 µΩ·cm or less, or 10 to 300 µΩ·cm, preferably 30 to 200 µΩ·cm.

The density of the deposition film may be 4.5 g/cm³ or more, or 4.5 to 5.5 g/cm³.

The deposition film may have an iodine atom count of 50 counts/s or more as measured by SIMS.

When injection and purging of the metal precursor and hydrogen iodide, and injection and purging of the reactant are considered 1 cycle, the following 4 conditions may all be satisfied: 1) the deposition film has a deposition thickness of 100 to 500 Å as measured by an ellipsometer, 2) the resistivity of the deposition film is 150 to 300 µΩ·cm, 3) the deposition rate is 0.34 to 0.535 Å/cycle, and 4) the density of the deposition film is 4.8 to 5.5 g/cm³.

For example, the method of manufacturing a deposition film may be performed using an apparatus for manufacturing an in-situ thin film or an ex-situ thin film including an ALD deposition chamber 10, the activator generator 20 for generating hydrogen iodide, a first vaporizer (not shown) for vaporizing hydrogen iodide, the stream 1 for transporting vaporized hydrogen iodide into the ALD deposition chamber 10, a second vaporizer (not shown) for vaporizing a metal precursor from the precursor feeder 30, the stream 2 for transporting the vaporized deposition film precursor into the ALD deposition chamber 10, the stream 3 for transporting a reactant from the reactant feeder 40 into the ALD deposition chamber 10, the stream 4 for transporting inert gas from the inert gas feeder 50 as a purging gas into the ALD deposition chamber 10, a stream 6 for supplying inert gas from the inert gas feeder 50 to the precursor feeder 30 as an additional transport means, and the stream 5 for supplying inert gas from the inert gas feeder 50 to the reactant feeder 40 as an additional transport means. Here, the vaporizers and streams, etc., are not particularly limited as long as the vaporizers and streams are vaporizers and streams commonly used in the technical field to which the present invention pertains.

In addition, the present invention may produce hydrogen iodide by the ex-situ method shown in FIG. 4 below. FIG. 4 below is a schematic diagram of a manufacturing process for producing hydrogen iodide by an ex-situ method.

According to FIG. 4 below, a plasma-hydrogen iodide generator (activator generator, reference numeral 20) is connected to a deposition chamber as shown in FIG. 2 below to deposit a thin film in-situ, and it may be inferred that hydrogen iodide has been generated through an increase in thin film growth rate and a decrease in resistivity.

However, depending on the synthesis process conditions, unreacted iodine may flow into the deposition chamber or the inside of the thin film in the process of manufacturing an in-situ thin film or an ex-situ thin film, and depending on deposition conditions, for example, when the deposition temperature is low, the introduced iodine may not be sublimated and removed but remain in the thin film, which may limit direct application to some semiconductor processes.

This problem may be solved when a filtration device is added between the activator generator 20 of FIG. 2 below and the chamber (reference numeral 10) of FIG. 2 below.

For example, the filtration device may be a refrigerator such as a cold trap, or may be a particle filter, etc.

For example, as shown in FIG. 4 below, a refrigerator 24 such as a cold trap may be added to the rear end of the activator generator to liquefy and compress after passing through it, and then fill into a cylinder.

Specifically, the apparatus may include a purifier for removing impurities from the hydrogen iodide gas converted in the activator generator through the purifier, and freezing and liquefying the hydrogen iodide gas; and a particle filter for removing impurities from the hydrogen iodide gas purified in the purifier.

### Semiconductor substrate

The present invention also provides a semiconductor substrate, characterized in that the semiconductor substrate is manufactured by the method of forming a deposition film of the present disclosure or includes the deposition film. In this case, step coverage of the deposition film and thickness uniformity of the deposition film may be significantly excellent, and the density and electrical properties of the deposition film may be excellent.

As described above, the change in the adsorption state of the quasi-metal precursor before and after ligand exchange may be formed by a reaction on the substrate between the metal precursor and hydrogen iodide containing a halogen for filling the ligand leaving site of the aforementioned metal precursor.

For example, the semiconductor substrate may include a deposition film formed through a process in which a ligand bound to the central metal of a metal precursor is substituted with iodine constituting hydrogen iodide, and then the site from which the iodine has departed is substituted with nitrogen (N) or the like.

For example, the deposition film may have a multilayer structure of two or more layers, a multilayer structure of three or more layers, or a multilayer structure of two or three layers as needed. The multilayer film of a two-layer structure may be, as a specific example, a lower layer film-middle layer film structure, and the multilayer film of a three-layer structure may be, as a specific example, a lower layer film-middle layer film-upper layer film structure.

As a specific example, the deposition film may be a middle layer film (TiN electrode for DRAM or barrier film for NAND).

For example, the lower layer film may include one or more selected from the group consisting of Si, SiO₂, MgO, Al₂O₃, CaO, ZrSiO₄, ZrO₂, HfSiO₄, Y₂O₃, HfO₂, LaLuO₂, Si₃N₄, SrO, La₂O₃, Ta₂O₅, BaO, and TiO₂.

For example, the upper layer film may include one or more selected from the group consisting of W and Mo.

### Semiconductor device

According to the present invention, a semiconductor device including the aforementioned semiconductor substrate may be provided.

For example, the semiconductor device may be low resistive metal gate interconnects, high aspect ratio 3D metal-insulator-metal (MIM) capacitors, DRAM trench capacitors, 3D Gate-All-Around (GAA), or 3D NAND flash memory, etc.

Hereinafter, preferred examples and drawings are presented to help understand the present invention, but the following examples and drawings are only illustrative of the present invention, and it is obvious to those skilled in the art that various changes and modifications are possible within the scope and technical idea of the present invention. Such changes and modifications fall within the scope of the appended patent claims.

### [Examples]

### Manufacturing of in-situ thin film

TiCl₄ was prepared as a metal precursor, the activator generator 20 of FIG. 2 below was equipped with a plasma generator generating plasma of the value shown in Table 1 below, and an in-situ thin film or ex-situ thin film was manufactured according to FIGS. 1 to 5 (particularly, process diagrams 1, 2, and 3 of FIG. 5 below) at a deposition temperature of 400 °C.

Specific experimental methods of Examples 1 to 3 and Comparative Examples 1 and 2 were performed using the materials under specific experimental conditions described in Table 1 below.

As a specific example, the process of Example 1 may be performed as follows.

An internal atmosphere of the deposition chamber 10 was formed such that a working pressure became 1 Torr by injecting 1000 sccm of argon into the deposition chamber 10 through a mass flow controller (MFC). A silicon wafer was placed to correspond to the deposition temperature, and a heating block was heated (see FIG. 2 below).

The canister 30 filled with the precursor was heated or cooled so that the vapor pressure at which the TiCl₄ precursor is injected into the deposition chamber 10 became 0.01 to 10 Torr, and the precursor was introduced into the deposition chamber 10 in a vapor state. The precursor vapor was injected into the deposition chamber 10 for 1 to 30 seconds, and then the precursor vapor was purged for a time equal to twice the precursor injection time.

High-purity hydrogen iodide was generated by putting iodine (I₂) pellets into the activator generator 10, and oscillating plasma at an output of 50 to 400 W under a condition where a mixed gas of 4% H₂ and 96% Ar is supplied from the vessel V5 to the activator generator 10 at 200 to 1000 sccm using a 13.56 MHz hollow cathode RF-generator as a plasma generator.

The high-purity hydrogen iodide generated in this way was injected into the deposition chamber 10 for 1 to 30 seconds in-situ as an activator, and then the activator was purged for a time equal to twice the activator injection time.

Thereafter, 200 to 1000 sccm of gaseous NH₃ reactant was injected into the deposition chamber 10 from the reactant feeder 40 (corresponding to vessel V6) through a mass flow controller (MFC) for 1 to 100 seconds, and then the reactant was purged for a time equal to twice the precursor injection time.

Such a process was repeated 200 to 400 times to manufacture an in-situ thin film.

With respect to the in-situ thin films obtained in Examples 1 and 2 and Comparative Examples 1 to 3, the deposition rate (GPC) and resistivity were measured while checking the thin film thickness according to the measurement method described below, and are shown together in Table 1 below.

### <Measurement Method>

*Thin film thickness: Measured under room temperature and atmospheric pressure conditions using an ellipsometer.
*Deposition rate: Calculated using Equation 1 below.
   [Equation 1] $Deposition rate = thin film thickness / number of depositions$
*Resistivity (Ω·m): Measured under room temperature and atmospheric pressure conditions using a sheet resistance meter and converted into resistivity in consideration of the thin film thickness.

**[Table 1]**

| Experime ntal Examples | Precur sor | React ant | Activator generator conditions | | | | Experimental results | |
|---|---|---|---|---|---|---|---|---|
| | | | Compon ent 1 | Compon ent 2 | Outp ut (W) | Temperat ure (°C) | GP C | Resisti vity |
| Comparat ive Example 1 | TiCl₄ | NH₃ | Unused | Unused | Unus ed | 20 | 0.4 42 | 920 |
| Comparat ive Example 2 | TiCl₄ | NH₃ | I₂ | H₂/Ar | 0 | 20 | 0.4 67 | 715 |
| Comparat ive Example 3 | TiCl₄ | NH₃ | I₂ | H₂/Ar | 0 | 40 | 0.4 70 | 805 |
| Example 1 | TiCl₄ | NH₃ | I₂ | H₂/Ar | 80 | 20 | 0.5 23 | 650 |
| Example 2 | TiCl₄ | NH₃ | I₂ | H₂/Ar | 80 | 40 | 0.6 81 | 520 |

As shown in Table 1, the experimental results according to Examples 1 and 2 confirmed that TiN thin film properties with increased GPC and decreased resistivity were provided under appropriate process conditions. These results are considered to be due to the activation effect in which hydrogen iodide is generated through reaction with I₂ by applying 80 W to the hollow cathode plasma to induce the formation of hydrogen radicals, and the hydrogen iodide thus generated substitutes the ligand (for example, Cl) of the precursor adsorbed on the substrate.

From the above results, it was confirmed that Examples 1 to 4 according to the in-situ deposition process applied directly to ligand exchange using hydrogen iodide showed significantly improved deposition rate increase rate and resistivity compared to Comparative Examples 1 and 2 which used hydrogen iodide but did not apply the hydrogen iodide by the in-situ method or the like.

In particular, the resistivity improvement according to Examples 1 and 2 of the present invention may be inferred to originate from thin film density improvement and impurity reduction. When resistivity is reduced by 50%, thin film density is estimated to improve by 10%, and impurities are estimated to reduce by 20%.

### Manufacturing of ex-situ thin film

FIG. 4 below is a schematic diagram of a manufacturing process for producing hydrogen iodide by an ex-situ method. According to FIG. 4 below, a plasma-hydrogen iodide generator (activator generator, reference numeral 20) was connected to a deposition chamber as shown in FIG. 2 below to deposit a thin film in-situ, and it could be inferred that hydrogen iodide was generated through an increase in thin film growth rate and a decrease in resistivity.

However, depending on the synthesis process conditions, unreacted iodine may flow into the deposition chamber or the inside of the thin film in the process of manufacturing an in-situ thin film or an ex-situ thin film. Depending on deposition conditions, for example, when the deposition temperature is low, the introduced iodine may not be sublimated and removed but remain in the thin film, which may limit direct application to some semiconductor processes.

To prevent the problem, a filtration device such as a cold trap or a particle filter may be sequentially added between the activator generator (reference numeral 20) and the chamber (reference numeral 10) of FIG. 2 below (see process diagram 2 of FIG. 5 below).

In addition, as shown in FIG. 4 below, a refrigerator 24 may be added to the rear end of the activator generator 20, and after passing through the refrigerator 24, the product may be liquefied and compressed to be filled into a cylinder.

When the activator generator 20 for supplying the activator is a nickel-plated gas cylinder, a self-assembled protective film in which a Ni-I atomic layer is formed on the uppermost part of the plated nickel may be formed to form the feeder inner wall in a passivation state.

When the feeder for supplying the reactant is a nickel-plated gas cylinder, a self-assembled protective film in which a Ni-I atomic layer is formed on the uppermost part of the plated nickel may be formed to form the feeder inner wall in a passivation state (see process diagram 3 of FIG. 5 below).

Consequently, when applying the hydrogen iodide of the present invention to the in-situ thin film or ex-situ thin film deposition process, it was confirmed that the thickness of the deposition film, deposition rate increase rate, density, and resistivity were all improved, and impurity reduction characteristics were also excellent, so that the deposition film was uniformly formed even on a substrate of a complex pattern.

### [Description of Symbols]

10: DEPOSITION CHAMBER
20: ACTIVATOR GENERATOR
21: SOLID IODINE-BASED COMPOUND STORAGE
22: HYDROGEN GAS STORAGE
23: HYDROGEN IODIDE GENERATOR
24: REFRIGERATOR
30: PRECURSOR FEEDER
31: METAL PRECURSOR STORAGE
40: REACTANT FEEDER
41: REACTANT STORAGE
50: INERT GAS FEEDER

## Claims

1. A method of manufacturing a thin film, comprising:
a process of converting to hydrogen iodide by supplying a solid iodine-based compound and hydrogen gas to an activator generator;
a process of substituting ligands of a metal precursor adsorbed on a substrate by supplying gas of hydrogen iodide converted in the activator generator to a chamber loaded with the substrate; and
a process of depositing an in-situ thin film or an ex-situ thin film by supplying a reactant to the chamber,
wherein the solid iodine-based compound comprises one or more selected from molecular iodine (I₂), ammonium iodide (NH₄I), and potassium iodide (KI).

2. The method according to claim 1, wherein the process of substituting ligands of a metal precursor adsorbed on a substrate by supplying gas of hydrogen iodide converted in the activator generator to a chamber loaded with the substrate is performed as a process of supplying the metal precursor to the chamber through a precursor feeder to generate a precursor on the substrate, and a process of substituting the ligands of the metal precursor adsorbed on the substrate using hydrogen iodide gas supplied to the chamber.

3. The method according to any preceding claim, wherein the activator generator performs a hydrogen iodide generation reaction using light with a wavelength of 100 to 300 nm, heat of 100 to 400 °C, or plasma of 10 to 100 MHz.

4. The method according to any preceding claim, wherein the metal precursor is a molecule having one or more selected from Al, Si, Ti, V, Cr, Mn, Fe, Co, Ni, Cu, Zn, Ga, Ge, Se, Y, Zr, Nb, Mo, Ru, Ph, In, Sn, Sb, Te, La, Ce, Hf, Ta, W, Re, Os, and Ir as central metals, having one or more elements of C, N, O, H, Si, S, P, F, and Cl as ligands, and having a molecular weight of 15 to 400 g/mol.

5. The method according to any preceding claim, wherein the reactant is oxygen, ozone, nitrogen monoxide, nitrogen dioxide, hydrogen, ammonia, hydrazine, or a derivative thereof.

6. The method according to any preceding claim, wherein the metal precursor, the hydrogen iodide, and the reactant are each transported to the chamber by a method independently selected from vapor flow control (VFC) to which mass flow control (MFC) is applied, mass flow control (MFC) to which liquid mass flow control (LMFC) is applied, or a liquid delivery system (LDS).

7. The method according to any preceding claim, wherein the carrier gas for transporting the metal precursor, the hydrogen iodide, or the reactant into the chamber is one or a mixture of two or more selected from argon (Ar), nitrogen (N₂), and helium (He).

8. The method according to any preceding claim, wherein the deposition is performed under a temperature condition of 10 to 1000 °C.

9. The method according to any preceding claim, wherein the metal precursor, the hydrogen iodide, and the reactant supplied into the chamber are each supplied through a showerhead onto a substrate placed on a heating block.

10. The method according to any preceding claim, wherein the in-situ thin film or the ex-situ thin film is a metal film, an oxide film, or a nitride film.

11. The method according to any preceding claim, wherein the deposition is atomic layer deposition (ALD), plasma-enhanced atomic layer deposition (PEALD), chemical vapor deposition (CVD), plasma-enhanced chemical vapor deposition (PECVD), metal-organic chemical vapor deposition (MOCVD), or low-pressure chemical vapor deposition (LPCVD).

12. The method according to any preceding claim, comprising a hydrogen iodide gas purification method comprising a process of removing impurities from the hydrogen iodide gas converted in the activator generator through a purifier, and freezing and liquefying the hydrogen iodide gas, wherein the process temperature is -200 to -5 °C.

13. The method according to claim 12, comprising a hydrogen iodide gas filtration method comprising a process of removing impurities from the hydrogen iodide gas purified in the purifier, wherein the particle filter has pores having a size of 0.1 to 1000 nm, and the particle filter is made of Teflon (PFA, PTFE, and derivatives thereof) or synthetic resin.

14. The method according to any preceding claim, wherein the ligands of the metal precursor adsorbed on the substrate is substituted with iodine derived from hydrogen iodide, and the iodine forms a deposition film through a reduction reaction with the reactant.

15. An apparatus for manufacturing a thin film, comprising a deposition chamber; an activator generator for converting to hydrogen iodide by supplying a solid iodine-based compound and hydrogen gas to the activator generator; a precursor feeder for adsorbing a metal precursor onto a substrate loaded in the deposition chamber; a reactant feeder for supplying a reaction gas to the deposition chamber (10); and an inert gas feeder for supplying a purging gas to the deposition chamber (10),
wherein each material provided to the deposition chamber through the activator generator, the precursor feeder, the reactant feeder, and the inert gas feeder is independently provided by a mass flow control (MFC) method, liquid mass flow control (LMFC), or a liquid delivery system (LDS).
